# EUROPÄISCHE PATENTSCHRIFT

(11) **EP 3 033 889 B1**
(45) Veröffentlichungstag und Bekanntmachung des Hinweises auf die Patenterteilung: **12.12.2018**
(21) Anmeldenummer: 14750170.4
(22) Anmeldetag: 04.08.2014
(51) Int. Cl.: H04Q 9/00, G01R 31/36, H01M 10/42, H04L 12/40

(54) **ELEKTROMECHANISCHER ADAPTER**
ELECTROMECHANICAL ADAPTER
ADAPTATEUR ÉLECTROMÉCANIQUE

(30) Priorität: 13.08.2013 DE 102013215968
(43) Veröffentlichungstag der Anmeldung: 22.06.2016
(73) Patentinhaber: Robert Bosch GmbH, 70442 Stuttgart (DE)
(72) Erfinder: SCHAEDLICH, Thomas, 70806 Kornwestheim (DE); WEBER, Jochen, 71679 Asperg (DE); TZIVANOPOULOS, Chrysanthos, 71686 Remseck Am Neckar (DE); BERGMANN, Sven, 70437 Stuttgart (DE)
(86) Internationale Anmeldenummer: PCT/EP2014/066714
(87) Internationale Veröffentlichungsnummer: WO 2015/022221

(56) Entgegenhaltungen:
- WO-A1-2012/095202
- DE-A1-102010 041 492
- DE-A1-102010 062 872
- US-B1- 7 576 517

## Beschreibung

### Stand der Technik

Die Erfindung geht aus von einem elektromechanischen Adapter mit mindestens einem Steuergerät.

Aus dem Stand der Technik sind Adapter bekannt, die Signalpegel zwischen zwei Schnittstellen umsetzen, so dass beispielsweise unterschiedliche Sensoren an einem Steuergerät betrieben werden können.

### Offenbarung der Erfindung

Nachteilig an dem bekannten Stand der Technik ist, dass sowohl jeder Adapter eine eigene Hardwareschaltung benötigt und zusätzlich jede Einheit, die an die Schnittstellen des Adapters angeschlossen ist, eine eigene Auswerteschaltung umfasst.

Aus dem Dokument WO 2012/095202 A1 ist eine Batteriemanagementeinheit mit einer Vielzahl von Überwachungseinheiten und einem Steuergerät bekannt. Dabei ist jede der Überwachungseinheiten dazu ausgebildet, mindestens eine Betriebsgröße mindestens einer Batteriezelle oder eines Batteriemoduls, welches eine vorbestimmte Anzahl von Batteriezellen umfasst, zu erfassen. Ferner ist jede der Überwachungseinheiten an einen ersten Bus angeschlossen. Das Steuergerät ist ebenfalls an den ersten Bus angeschlossen und dazu ausgebildet, über den ersten Bus mit mindestens einer der Überwachungseinheiten zu kommunizieren. Ferner umfasst das Steuergerät einen Mikrocontroller und eine Übersetzungseinheit. Dabei ist die Übersetzungseinheit an den ersten Bus angeschlossen und dazu ausgebildet, über den ersten Bus mit mindestens einer der Überwachungseinheiten zu kommunizieren. Ferner sind der Mikrocontroller und die Übersetzungseinheit an einen zweiten Bus angeschlossen und dazu ausgebildet, über den zweiten Bus miteinander zu kommunizieren.

Aus dem Dokument DE 10 2010 062 872 A1 ist eine Batteriemanagementeinheit mit einer Vielzahl von Überwachungs-IC Chips bekannt. Dabei ist jeder der Überwachungs-IC Chips an einen ersten Bus angeschlossen. Ferner ist einer der Überwachungs-IC Chips als Basis-Überwachungs-IC Chip eingesetzt, welcher ebenfalls an den ersten Bus angeschlossen und dazu ausgebildet ist, über einen zweiten Bus mit einem Steuergerät zu kommunizieren. Weiterhin ist jeder der Überwachungs-IC Chips dazu ausgebildet, eine Spannung einer Batteriezelle oder eines Batteriemoduls zu erfassen.

Aus dem Dokument US 7,576,517 B1 ist ein Batterieüberwachungssystem bekannt, der jeweils über eine Schnittstelle mit einer ersten Batterieüberwachungseinheit und mit einer zweiten Batterieüberwachungseinheit verbunden werden kann. Die erste Batterieüberwachungseinheit ist dazu ausgebildet, Daten in einem ersten Format auszugeben. Die zweite Batterieüberwachungseinheit ist dazu ausgebildet, Daten in einem gegenüber dem ersten Format unterschiedlichen zweiten Format auszugeben. Das Batterieüberwachungssystem umfasst ein erstes Datenabfragungsmittel, das dazu ausgebildet ist, Daten von der ersten Batterieüberwachungseinheit zu empfangen und diese in einem vordefinierten Format zu normieren und zu speichern. Das Batterieüberwachungssystem umfasst ferner ein zweites Datenabfragungsmittel, das dazu ausgebildet ist, Daten von der zweiten Batterieüberwachungseinheit zu empfangen und diese in einem vordefinierten Format zu normieren und zu speichern. Weiterhin ist das Batterieüberwachungssystem dazu ausgebildet, Daten bezüglich eines Zustands einer mit jeder Batterieüberwachungseinheit verbundenen Batterieeinheit auszugeben.

Aus dem Dokument DE 10 2010 041 492 A1 ist ein Verfahren zur Überwachung mindestens einer Batterie bekannt, wobei Messgrößen von zumindest einer der mindestens einen Batterie durch mindestens eine Datenverarbeitungseinrichtung ausgewertet werden. Dabei erfolgt mindestens eine Überwachung von Signalen, die über eine Kommunikationsverbindung zwischen der mindestens einen Batterie und der mindestens einen Datenverarbeitungseinrichtung ausgetauscht werden. Ferner erfolgt eine Plausibilitätsprüfung zumindest eines Teils der Signale.

### Vorteile der Erfindung

Die erfindungsgemäße Vorgehensweise mit den kennzeichnenden Merkmalen der unabhängigen Ansprüche weist demgegenüber den Vorteil auf, dass der elektromechanische Adapter mindestens ein Steuergerät umfasst, wobei der Adapter mindestens eine erste Schnittstelle zur Kommunikation mit mindestens einer batterieseitigen Überwachungseinheit eine zweite Schnittstelle zur Kommunikation mit einer der batterieseitigen Überwachungseinheit übergeordneten Überwachungseinheit, sowie eine dritte Schnittstelle zur Anbindung von mindestens einem Sensor und/oder Aktuator umfasst, wobei das Steuergerät Signale zwischen der ersten und der zweiten Schnittstelle durch eine in Abhängigkeit eines Sensorsignals der dritten Schnittstelle durchgeführte Anpassung einer Signalform und/oder eines Signalpegels umsetzt.

Weitere vorteilhafte Ausführungsformen der vorliegenden Erfindung sind Gegenstand der Unteransprüche.

Vorteilhafterweise umfasst der elektromechanische Adapter mindestens eine weitere Komponente zur Umsetzung der Signale, beispielsweise ein CAN-Bus Kontroller und/oder eine programmierbare Komponente. Durch die programmierbare Komponente kann beispielsweise eine Anpassung der Umsetzung der Signale an neue Kommunikationsprotokolle erfolgen, ohne dass die weitere Komponente und/oder der elektromechanische Adapter getauscht werden muss.

Die erste Schnittstelle umfasst eine serielle Schnittstelle, die vorteilhafterweise Daten asynchron überträgt und eine Fehlererkennung bzw. Fehlerkorrektur umfasst, wodurch Kommunikationsfehler erkannt werden.

Die erste Schnittstelle, die zweite Schnittstelle und/oder die dritte Schnittstelle umfassen vorteilhafterweise Steckverbindungen, so dass eine bauraumoptimierte Verwendung des elektromechanischen Adapters möglich ist und/oder der elektromechanische Adapter lösbar mit beispielsweise einer Steuereinheit, einer Kommunikationsleitung, einem Sensor, einem Aktuator und/oder einer Überwachungseinheit verbunden ist.

Vorteilhafterweise umfasst das Steuergerät des elektromechanischen Adapters ein Verfahren, welches Signale zwischen der ersten Schnittstelle und der zweiten Schnittstelle durch eine in Abhängigkeit eines Sensorsignals der dritten Schnittstelle durchgeführte Anpassung einer Signalform und/oder eines Signalpegels der Signale umsetzt. Dabei führt das Steuergerät vorteilhafterweise durch das Sensorsignal der dritten Schnittstelle eine Anpassung der Umsetzung der Signale zwischen der ersten Schnittstelle und der zweiten
Schnittstelle und/oder eine Fehlerbehandlung durch.

Vorteilhafterweise führt das Steuergerät eine Plausibilitätsprüfung der Signale durch, beispielsweise anhand eines Signalvergleichs von Signalen, die mit unterschiedlichen Messmethoden und/oder unterschiedlichen Sensoren erfasst werden und/oder Signale mit vorgegebenen Schwellenwerten für Extrema und/oder Mittelwerte vergleicht.

Hierdurch kann in einer ersten vorteilhaften Ausführungsform das Steuergerät Signale blockieren, die außerhalb der vorgegebenen Schwellenwerte liegen, wodurch Folgefehler verhindert werden, beispielsweise durch Überschreitung einer maximalen Spannung.

In einer zweiten Ausführungsform verwendet das Steuergerät gespeicherte Ersatzwerte für die Signale, beispielsweise wird der gespeicherte maximale Schwellenwert verwendet, wenn ein Signal diesen maximalen Schwellenwert überschreitet.

In einer dritten Ausführungsform passt das Steuergerät eine Abtastfrequenz zur Erfassung der Signale an, beispielsweise wird die Abtastfrequenz erhöht, wenn die verglichenen Signale innerhalb eines Toleranzbereichs voneinander abweichen, um eine frühzeitige Erkennung eines Normalzustands zu gewährleisten. Weichen die verglichenen Signale nicht mehr voneinander ab, wird die Abtastfrequenz wieder verringert.

In einer vierten Ausführungsform steuert das Steuergerät einen Aktuator an, wenn die Signale bei der Plausibilitätsprüfung voneinander abweichen. Vorteilhafterweise gibt das Steuergerät ein Alarmsignal aus, so dass weitere Überwachungseinheiten Maßnahmen für eine Fehlerbehandlung ergreifen können, beispielsweise durch Öffnen von Schützen eine Batterie von einem elektrischen Antrieb eines Fahrzeugs trennen.

Vorteilhafterweise erkennt das Steuergerät anhand der Signalform und/oder des Signalpegels Signalerfassungsfehler, beispielsweise fehlerhafte Sensoren, defekte Kabel, und/oder Kommunikationsfehler, beispielsweise durch Störeinkopplungen auf einer elektrischen Leitung zwischen dem elektromechanischen Adapter und einer weiteren Steuereinheit. In Abhängigkeit der Plausibilitätsprüfung gibt das Steuergerät ein Alarmsignal an der dritten Schnittstelle aus.

Der elektromechanische Adapter wird in einer batterieseitigen Überwachungseinheit und/oder in einer Kommunikationsverbindung zwischen einer batterieseitigen Überwachungseinheit und einer der batterieseitigen Überwachungseinheit übergeordneten zentralen Überwachungseinheit und/oder in einer der batterieseitigen Überwachungseinheit übergeordneten zentralen Überwachungseinheit verwendet, vorteilhafterweise durch ein Umstecken der Kommunikationsleitungen mittels der lösbaren Steckverbindung des elektromechanischen Adapters.

### Kurzbeschreibung der Figuren

Ausführungsbeispiele der Erfindung sind in der Zeichnung dargestellt und in der nachfolgenden Beschreibung näher erläutert.

Es zeigt:
- Figur 1: eine Batteriemanagementarchitektur gemäß dem Stand der Technik;
- Figur 2a: ein Beispiel für eine Verwendung des erfindungsgemäßen elektromechanischen Adapters in einer batterieseitigen Überwachungseinheit;
- Figur 2b: ein Beispiel für eine Verwendung des erfindungsgemäßen elektromechanischen Adapters in einer Kommunikationsverbindung zwischen einer batterieseitigen Überwachungseinheit und einer der batterieseitigen Überwachungseinheit übergeordneten zentralen Überwachungseinheit;
- Figur 2c: ein Beispiel für eine Verwendung des erfindungsgemäßen elektromechanischen Adapters in einer der batterieseitigen Überwachungseinheit übergeordneten zentralen Überwachungseinheit;
- Figur 3: eine Ausführungsform des erfindungsgemäßen elektromechanischen Adapters.

### Detaillierte Beschreibung der Ausführungsbeispiele

Gleiche Bezugszeichen bezeichnen in allen Figuren gleiche Vorrichtungskomponenten.

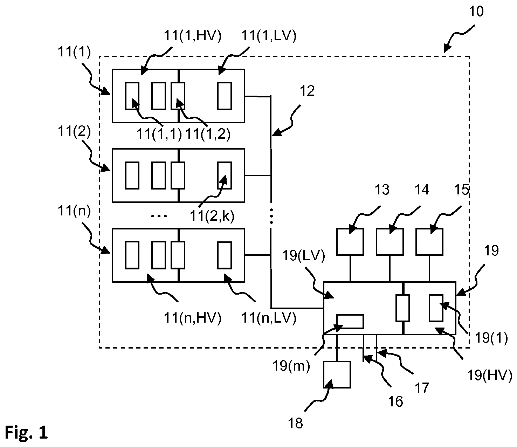

Figur 1 zeigt ein Batteriemanagementsystem (battery management system, BMS) mit einer Batteriemanagementarchitektur 10 gemäß dem Stand der Technik. Mindestens eine Überwachungseinheit 11(1), 11(2), 11(n) zur Überwachung mindestens einer Batteriezelle ist mittels einer Kommunikationsschnittstelle über Kommunikationsbus 12 mit einer zentralen Steuereinheit 19 (battery control unit, BCU) verbunden.

Die Überwachungseinheit 11(1), 11(2), 11(n) zur Überwachung der mindestens einen Batteriezelle umfasst beispielsweise einen Hochvolt-Teil 11(1,HV), 11(n,HV) und beispielsweise einen Niedervolt-Teil 11(1,LV), 11(n,LV) und mindestens eine weitere Komponente 11(1,1), 11(1,2), 11(2,k), beispielsweise zur Kopplung des Hochvolt-Teils 11(1,HV), 11(n,HV) und des Niedervolt-Teils 11(1,LV), 11(n,LV) und/oder einen Kommunikationstreiber für den Kommunikationsbus 12.

Die zentrale Steuereinheit 19 umfasst einen Hochvolt-Teil 19(HV) und einen Niedervolt-Teil 19(LV), sowie mindestens eine weitere Komponente 19(1), 19(m), beispielsweise zur Kopplung des Hochvolt-Teils 19(HV) und des Niedervolt-Teils 19(LV) und/oder einen Kommunikationstreiber für den Kommunikationsbus 12. Die zentrale Steuereinheit 19 umfasst weitere Kommunikationsverbindungen, beispielsweise um Signale von mindestens einem Sensor zu empfangen und/oder mindestens einen Aktuator anzusteuern. Der mindestens eine Sensor ist beispielsweise ein mit dem Hochvolt-Teil 19(HV) verbundener Shunt-Sensor 15 und/oder ein mit dem Niedervolt-Teil 19(LV) verbundener Hall-Sensor 14. Der mindestens eine Aktuator umfasst beispielsweise eine Einheit 13 (battery disconnect unit, BDU) zur galvanischen Trennung des Hochvolt-Teils 19(HV) zwischen einer, mindestens eine Batteriezelle umfassenden, Batterie und einer Ladestation zum Laden der Batterie.

Die zentrale Steuereinheit 19 ist über die mindestens eine weitere Komponente 19(1), 19(m) mit mindestens einer weiteren Einheit 18 verbunden, beispielsweise einer zentralen Fahrzeugsteuereinheit (vehicle control unit, VCU). Weiterhin umfasst die zentrale Steuereinheit 19 weitere Kommunikationsverbindungen 16, 17, um ein Signal zu empfangen, beispielsweise eines Hochvolt-Interlock-Schaltkreises und/oder eines Signals bei einem durch die weitere Einheit 18 erkannten Unfalls eines Fahrzeugs. Wird beispielsweise der Hochvolt-Interlock-Schaltkreis unterbrochen, steuert die zentrale Steuereinheit 19 die Einheit 13 an und trennt die Batterie von der Ladestation.

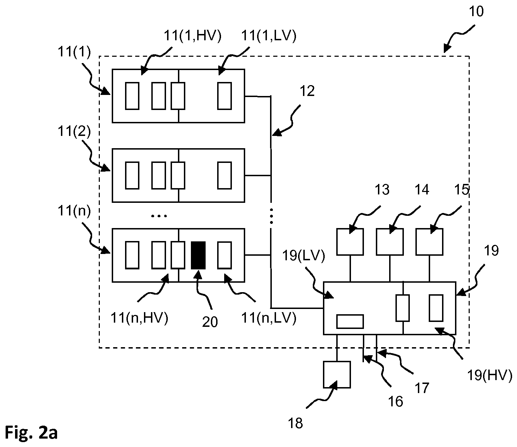

Figur 2a zeigt ein Beispiel für eine Verwendung des erfindungsgemäßen elektromechanischen Adapters 20 in einer batterieseitigen Überwachungseinheit 11(n). In einer weiteren Ausführungsform umfasst jede batterieseitige Überwachungseinheit 11(1), 11(2), 11(n) einen elektromechanischen Adapter 20. Vorteilhafterweise sind die Überwachungseinheiten 11(1), 11(2), 11(n) in dieser Ausführungsform eigensicher, da eine Überwachung auf ein thermisches Durchgehen der Batteriezelle in der Überwachungseinheit 11(1), 11(2), 11(n) stattfindet und mittels des elektromechanischen Adapter 20 mit zentralen Steuereinheiten kommuniziert wird.

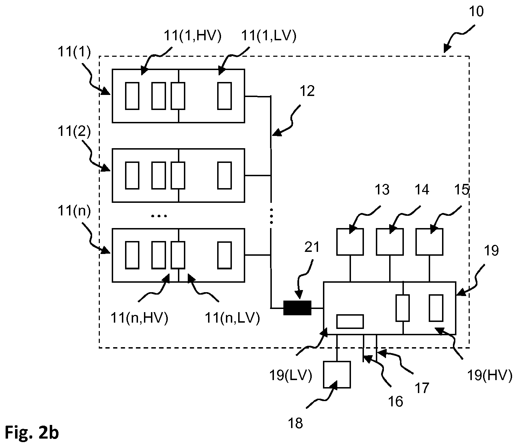

Figur 2b zeigt ein Beispiel für eine Verwendung des erfindungsgemäßen elektromechanischen Adapters 20 in einer Kommunikationsverbindung 12 zwischen einer batterieseitigen Überwachungseinheit 11(n) und einer den batterieseitigen Überwachungseinheiten 11(1), 11(2), 11(n) übergeordneten zentralen Überwachungseinheit 19.

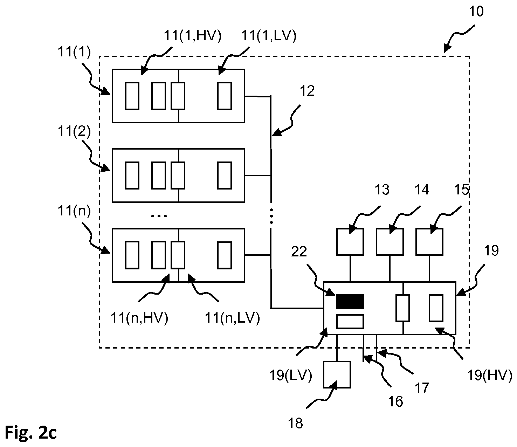

Figur 2c zeigt ein Beispiel für eine Verwendung des erfindungsgemäßen elektromechanischen Adapters 20 innerhalb einer der batterieseitigen Überwachungseinheit 11(1), 11(2), 11(n) übergeordneten zentralen Überwachungseinheit 19.

Vorteilhafterweise umfasst in einer ersten Ausführungsform die zentrale Überwachungseinheit 19 den elektromechanischen Adapter 20 vollständig, beispielsweise in Form einer in einem Gehäuse der zentralen Überwachungseinheit 19 angeordneten Platine, wobei mindestens eine Schnittstelle des elektromechanischen Adapters 20 über eine weitere Schnittstelle mit einer Kommunikationsverbindung 12 verbunden ist.

In einer zweiten vorteilhaften Ausführungsform umfasst die zentrale Überwachungseinheit 19 den elektromechanischen Adapter 20 in der Art, dass die mindestens eine Schnittstelle des elektromechanischen Adapters 20 direkt mit der Kommunikationsverbindung 12 verbunden ist.

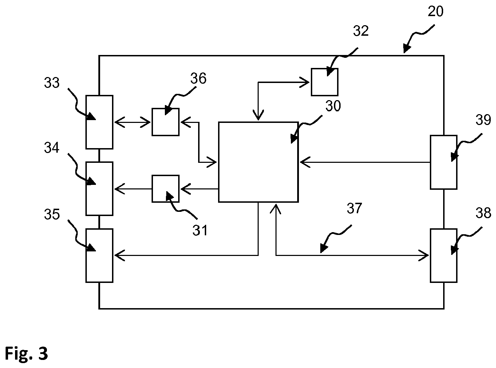

In Figur 3 ist eine Ausführungsform des erfindungsgemäßen elektromechanischen Adapters 20 mit mindestens einem Steuergerät 30 offenbart. Über mindestens eine Schnittstelle 38 ist der elektromechanische Adapter 20 mittels einer Kommunikationsverbindung 12 mit mindestens einer batterieseitigen Überwachungseinheit 11(1), 11(2), 11(n) verbunden. Die Kommunikationsverbindung 12 ist vorteilhafterweise eine serielle Schnittstelle, beispielsweise ein UART (universal asynchronous receiver transmitter) oder ein SPI (serial peripheral interface).

Der elektromechanische Adapter 20 umfasst mindestens eine Schnittstelle 33, 34 für eine Kommunikation zwischen einer zentralen Steuereinheit 19, beispielsweise eine den batterieseitigen Überwachungseinheiten 11(1), 11(2), 11(n) übergeordneten Überwachungseinheit, und/oder einer weiteren Steuereinheit. Für eine Kommunikation zwischen dem Steuergerät 30 und der zentralen Steuereinheit 19 umfasst der elektromechanische Adapter 20 mindestens eine weitere Komponente 31, 36, beispielsweise einen CAN-Bus Kontroller und/oder mindestens eine programmierbare Komponente, wie beispielsweise CPLD (complex programmable logic device) oder FPGA (field programmable gate array). Signale zwischen der ersten (38) und der zweiten Schnittstelle (33, 34) werden durch das Steuergerät (30) und/oder von einer weiteren Komponente (31, 36) des elektromechanischen Adapters (20) durch eine Anpassung einer Signalform und/oder eines Signalpegels umgesetzt. Hierdurch ist vorteilhafterweise eine Umsetzung der Signale von einem ersten Kommunikationsprotokoll der ersten Schnittstelle in ein zweites Kommunikationsprotokoll der zweiten Schnittstelle möglich, wobei beispielsweise auch ein Wertebereich und/oder eine physikalische Einheit einer Signalnachricht umgerechnet wird.

Der elektromechanische Adapter 20 umfasst mindestens eine weitere Schnittstelle, beispielsweise eine Schnittstelle 39 für ein Überspannungs- bzw. Unterspannungssignal und/oder einen Widerstand von einem Heißleiter (negative temperature coefficient thermistors, NTC), sowie eine Schnittstelle 35 für eine Ansteuerung von mindestens einem Aktuator.

Der elektromechanische Adapter 20 umfasst mindestens eine weitere Komponente 32, wie beispielsweise einen Watchdog, der vorteilhafterweise über ein SPI (serial peripheral interface) mit dem Steuergerät 30 verbunden ist.

Vorteilhafterweise setzt der elektromechanische Adapter 20 und/oder die mindestens eine weitere Komponente 31, 36 Signale zwischen der ersten Schnittstelle 38 bzw. der zweiten Schnittstelle 33, 34 und der dritten Schnittstelle 35, 39 um.

## Patentansprüche

1. Elektromechanischer Adapter (20) mit mindestens einem Steuergerät (30), wobei der Adapter (20) mindestens eine erste Schnittstelle (38) zur Kommunikation mit mindestens einer batterieseitigen Überwachungseinheit (11(1), 11(2), 11 (n)) und eine zweite Schnittstelle (33, 34) zur Kommunikation mit einer der batterieseitigen Überwachungseinheit (11(1), 11(2), 11(n)) übergeordneten Überwachungseinheit (19) umfasst, **dadurch gekennzeichnet, dass** der Adapter (20) eine dritte Schnittstelle (35, 39) zur Anbindung von mindestens einem Sensor und/oder Aktuator umfasst, wobei das Steuergerät (30) Signale zwischen der ersten (38) und der zweiten Schnittstelle (33, 34) durch eine in Abhängigkeit eines Sensorsignals der dritten Schnittstelle (35, 39) durchgeführte Anpassung einer Signalform und/oder eines Signalpegels umsetzt.

2. Elektromechanischer Adapter (20) nach Anspruch 1, **dadurch gekennzeichnet, dass** der elektromechanische Adapter (20) zur Umsetzung der Signale mindestens eine weitere Komponente (31, 36) umfasst.

3. Elektromechanischer Adapter (20) nach einem der vorhergehenden Ansprüche, **dadurch gekennzeichnet, dass** die weitere Komponente (31, 36) einen CAN-Bus Kontroller und/oder eine programmierbare Komponente umfasst.

4. Elektromechanischer Adapter (20) nach einem der vorhergehenden Ansprüche, **dadurch gekennzeichnet, dass** die erste Schnittstelle (38) eine serielle Schnittstelle ist.

5. Elektromechanischer Adapter (20) nach einem der vorhergehenden Ansprüche, **dadurch gekennzeichnet, dass** die erste Schnittstelle (38), die zweite Schnittstelle (33, 34) und/oder die dritte Schnittstelle (35, 39) Steckverbindungen umfassen.

6. Verfahren zum Betreiben eines elektromechanischen Adapters (20) mit mindestens einem Steuergerät (30), **dadurch gekennzeichnet, dass** Signale zwischen der ersten (38) und der zweiten Schnittstelle (33, 34) durch das Steuergerät (30) des elektromechanischen Adapters (20) und/oder von einer weiteren Komponente (31, 36) des elektromechanischen Adapters (20) durch eine in Abhängigkeit eines Sensorsignals einer dritten Schnittstelle (35, 39) des elektromechanischen Adapters (20) durchgeführte Anpassung einer Signalform und/oder eines Signalpegels umgesetzt werden.

7. Verfahren nach Anspruch 6, **dadurch gekennzeichnet, dass** das Steuergerät (30) eine Plausibilitätsprüfung der Signale durchführt.

8. Verfahren nach Anspruch 7, **dadurch gekennzeichnet, dass** das Steuergerät (30) die Plausibilitätsprüfung anhand eines Signalvergleichs von Signalen durchführt, die mit unterschiedlichen Messmethoden und/oder unterschiedlichen Sensoren erfasst werden und/oder Signale mit vorgegebenen Schwellenwerten für Extrema und/oder Mittelwerte vergleicht.

9. Verfahren nach Anspruch 8, **dadurch gekennzeichnet, dass** das Steuergerät (30) Signale blockiert, die außerhalb der vorgegebenen Schwellenwerte liegen, gespeicherte Ersatzwerte für die Signale verwenden, eine Abtastfrequenz zur Erfassung der Signale anpasst und/oder einen Aktuator ansteuert, wenn die verglichenen Signale voneinander abweichen.

10. Verfahren nach einem der Ansprüche 6 bis 9, **dadurch gekennzeichnet, dass** das Steuergerät (30) anhand der Signalform und/oder des Signalpegels Signalerfassungsfehler und/oder Kommunikationsfehler erkennt.

11. Verfahren nach einem der Ansprüche 6 bis 10, **dadurch gekennzeichnet, dass** das Steuergerät (30) in Abhängigkeit der Plausibilitätsprüfung, von Signalerfassungsfehlern und/oder Kommunikationsfehlern ein Alarmsignal an der dritten Schnittstelle (35, 39) ausgibt.

12. Verwendung eines elektromechanischen Adapters (20) gemäß einem der Ansprüche 1 bis 5 in einer batterieseitigen Überwachungseinheit (11(1), 11(2), 11(n)) und/oder in einer Kommunikationsverbindung (12) zwischen einer batterieseitigen Überwachungseinheit (11(1), 11(2), 11(n)) und einer der batterieseitigen Überwachungseinheit (11(1), 11(2), 11(n)) übergeordneten zentralen Überwachungseinheit (19) und/oder in einer der batterieseitigen Überwachungseinheit (11(1), 11(2), 11(n)) übergeordneten zentralen Überwachungseinheit (19).

## Claims

1. Electromechanical adapter (20) having at least one controller (30), wherein the adapter (20) comprises at least one first interface (38) for communication with at least one battery-side monitoring unit (11(1), 11(2), 11(n)) and a second interface (33, 34) for communication with a monitoring unit (19) that is at a higher level than the battery-side monitoring unit (11(1), 11(2), 11(n)), **characterized in that** the adapter (20) comprises a third interface (35, 39) for interfacing at least one sensor and/or actuator, wherein the controller (30) converts signals between the first interface (38) and the second interface (33, 34) by adapting a signal waveform and/or a signal level, said adaptation being carried out according to a sensor signal from the third interface (35,39).

2. Electromechanical adapter (20) according to Claim 1, **characterized in that** the electromechanical adapter (20) comprises at least one further component (31, 36) for converting the signals.

3. Electromechanical adapter (20) according to any of the previous claims, **characterized in that** the further component (31, 36) comprises a CAN-bus controller and/or a programmable component.

4. Electromechanical adapter (20) according to any of the previous claims, **characterized in that** the first interface (38) is a serial interface.

5. Electromechanical adapter (20) according to any of the previous claims, **characterized in that** the first interface (38), the second interface (33, 34) and/or the third interface (35, 39) comprise plug-in connections.

6. Procedure for operating an electromechanical adapter (20) comprising at least one controller (30), **characterized in that** signals between the first interface (38) and the second interface (33, 34) are converted by the controller (30) of the electromechanical adapter (20) and/or by a further component (31, 36) of the electromechanical adapter (20) by adapting a signal waveform and/or a signal level, said adaptation being carried out according to a sensor signal from a third interface (35, 39) of the electromechanical adapter (20).

7. Procedure according to Claim 6, **characterized in that** the controller (30) performs a plausibility check on the signals.

8. Procedure according to Claim 7, **characterized in that** the controller (30) performs the plausibility check by a signal-comparison of signals that are acquired by different measurement methods and/or different sensors, and/or compares signals with defined threshold values for extreme values and/or average values.

9. Procedure according to Claim 8, **characterized in that** the controller (30) blocks signals that lie outside the defined threshold values, uses stored substitute values for the signals, adapts a sampling frequency for the signal acquisition and/or actuates an actuator if the compared signals differ from one another.

10. Procedure according to any of Claims 6 to 9, **characterized in that** the controller (30) uses the signal waveform and/or the signal level to detect signal-acquisition errors and/or communication errors.

11. Procedure according to any of Claims 6 to 10, **characterized in that** the controller (30) controller outputs an alarm signal to the third interface (35, 39) on the basis of the plausibility check, signal-acquisition errors and/or communication errors.

12. Use of an electromechanical adapter (20) according to any of Claims 1 to 5 in a battery-side monitoring unit (11(1), 11(2), 11(n)) and/or in a communications connection (12) between a battery-side monitoring unit (11(1), 11(2), 11(n)) and a central monitoring unit (19) that is at a higher level than the battery-side monitoring unit ((11(1), 11(2), 11(n)), and/or in a central monitoring unit (19) that is at a higher level than the battery-side monitoring unit ((11(1), 11(2), 11(n)).

## Revendications

1. Adaptateur électromécanique (20) comportant au moins un appareil de commande (30), dans lequel l'adaptateur (20) comprend au moins une première interface (38) servant à communiquer avec au moins une unité de surveillance côté batterie (11(1), 11(2) 11(n)) et une deuxième interface (33, 34) servant à communiquer avec une unité de surveillance (19) de niveau supérieur à l'unité de surveillance côté batterie (11(1), 11(2), 11(n)), **caractérisé en ce que** l'adaptateur (20) comprend une troisième interface (35, 39) servant au raccordement d'au moins un capteur et/ou actionneur, dans lequel l'appareil de commande (30) convertit des signaux entre la première (38) et la deuxième interface (33, 34) en adaptant une forme de signal et/ou un niveau de signal en fonction d'un signal de capteur de la troisième interface (35, 39).

2. Adaptateur électromécanique (20) selon la revendication 1, **caractérisé en ce que** l'adaptateur électromécanique (20) comprend au moins un autre composant (31, 36) servant à convertir les signaux.

3. Adaptateur électromécanique (20) selon l'une des revendications précédentes, **caractérisé en ce que** l'autre composant (31, 36) comprend un contrôleur de bus CAN et/ou un composant programmable.

4. Adaptateur électromécanique (20) selon l'une des revendications précédentes, **caractérisé en ce que** la première interface (38) est une interface série.

5. Adaptateur électromécanique (20) selon l'une des revendications précédentes, **caractérisé en ce que** la première interface (38), la deuxième interface (33, 34) et/ou la troisième interface (35, 39) comprennent des connecteurs enfichables.

6. Procédé pour la mise en oeuvre d'un adaptateur électromécanique (20) comportant au moins un appareil de commande (30), **caractérisé en ce que** des signaux sont convertis entre la première (38) et la deuxième interface (33, 34) par l'appareil de commande (30) de l'adaptateur électromécanique (20) et/ou par un autre composant (31, 36) de l'adaptateur électromécanique (20) en adaptant une forme de signal et/ou un niveau de signal en fonction d'un signal de capteur d'une troisième interface (35, 39) de l'adaptateur électromécanique (20).

7. Procédé selon la revendication 6, **caractérisé en ce que** l'appareil de commande (30) effectue une vérification de vraisemblance des signaux.

8. Procédé selon la revendication 7, **caractérisé en ce que** l'appareil de commande (30) effectue la vérification de vraisemblance sur la base d'une comparaison de signaux qui sont détectés par différentes méthodes de mesure et/ou par différents capteurs et/ou compare des signaux à des valeurs de seuil prédéterminées pour des extrêmes et/ou des valeurs moyennes.

9. Procédé selon la revendication 8, **caractérisé en ce que** l'appareil de commande (30) bloque des signaux qui se situent en dehors des valeurs de seuil prédéterminées, utilise des valeurs de substitution mémorisées pour les signaux, adapte une fréquence de balayage pour détecter les signaux et/ou commande un actionneur lorsque les signaux comparés diffèrent les uns des autres.

10. Procédé selon l'une des revendications 6 à 9, **caractérisé en ce que** l'appareil de commande (30) identifie des erreurs de détection du signal et/ou des erreurs de communication en se basant sur la forme du signal et/ou le niveau du signal.

11. Procédé selon l'une des revendications 6 à 10, **caractérisé en ce que** l'appareil de commande (30) délivre un signal d'alarme à la troisième interface (35, 39) en fonction de la vérification de vraisemblance, d'erreurs de détection du signal et/ou d'erreurs de communication.

12. Utilisation d'un adaptateur électromécanique (20) selon l'une des revendications 1 à 5 dans une unité de surveillance côté batterie (11(1), 11(2), 11(n)) et/ou dans une liaison de communication (12) entre une unité de surveillance côté batterie (11(1), 11(2), 11(n)) et une unité centrale de surveillance (19) de niveau supérieur à l'unité de surveillance côté batterie (11(1), 11(2), 11(n)) et/ou dans une unité centrale de surveillance (19) de niveau supérieur à l'unité de surveillance côté batterie (11(1), 11(2), 11(n)).
